# DEMANDE DE BREVET EUROPEEN

(11) **EP 3 496 160 A1**
(43) Date de publication de la demande: **12.06.2019**
(21) Numéro de dépôt: 18210431.5
(22) Date de dépôt: 05.12.2018
(51) Int. Cl.: H01L 31/05

(54) **MODULE PHOTOVOLTAÏQUE COMPORTANT DES CELLULES PHOTOVOLTAÏQUES INTERCONNECTÉES PAR DES ÉLÉMENTS D'INTERCONNEXION**

(30) Priorité: 07.12.2017 FR 1761789
(71) Demandeur: Commissariat à l'énergie atomique et aux énergies alternatives, 75015 Paris (FR)
(72) Inventeur: COMMAULT, Benjamin, 73370 LE BOURGET-DU-LAC (FR); REY, Nicolas, 73100 AIX LES BAINS (FR)
(74) Mandataire: Brevalex

(57) **Abrégé**

L'objet principal de l'invention est un module photovoltaïque comportant : une première couche formant la face avant, des cellules photovoltaïques (4) interconnectées électriquement par des éléments d'interconnexion (6), un ensemble encapsulant les cellules (4), et une deuxième couche formant la face arrière. Ce module se caractérise en ce que chaque cellule (4) comporte, sur au moins l'une de ses faces avant (4a) et arrière (4b), un nombre pair d'éléments d'interconnexion (6) dont la longueur (I_{R}) au contact de la cellule (4) est inférieure à ses dimensions, en ce qu'une première moitié (M1) des éléments d'interconnexion (6) comprend des éléments (6) sensiblement parallèles, et en ce qu'une deuxième moitié (M2) des éléments d'interconnexion (6) comprend des éléments (6) sensiblement parallèles.

## Description

### DOMAINE TECHNIQUE

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin.

L'invention peut être mise en oeuvre pour de nombreuses applications, notamment pour des bâtiments tels que des habitats ou locaux industriels (tertiaires, commerciaux, ...), par exemple pour la réalisation de leurs toitures, pour la conception de mobilier urbain, par exemple pour de l'éclairage public, la signalisation routière ou encore la recharge de voitures électriques, voire également être utilisée pour des applications nomades, en particulier pour une intégration sur des voitures, bus ou bateaux, entre autres.

L'invention propose ainsi un module photovoltaïque comportant des cellules photovoltaïques interconnectées par des éléments d'interconnexion, notamment sous forme de rubans, ainsi qu'un procédé d'interconnexion électrique de cellules photovoltaïques et un procédé de fabrication d'un module photovoltaïque associés.

### ÉTAT DE LA TECHNIQUE ANTÉRIEURE

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, présentant une épaisseur typiquement comprise entre 2 et 4 mm, classiquement de l'ordre de 3 mm.

La deuxième couche formant la face arrière du module photovoltaïque peut quant à elle être réalisée à base de verre ou de métal, entre autres. Elle est souvent formée par une structure monocouche ou multicouche polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 400 µm. Elle peut de plus contenir une feuille d'aluminium.

Les cellules photovoltaïques, se présentant sous forme de fines plaques d'environ 200 µm d'épaisseur, peuvent être reliées électriquement entre elles (interconnectées) par des éléments de contact électrique avant et arrière, appelés conducteurs de liaison, et formés par exemple par des bandes (ou rubans) ou fils de cuivre étamé, notamment respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'encapsulant peut présenter une épaisseur d'au moins 0,2 mm et un module de Young typiquement compris entre 2 et 400 MPa à température ambiante.

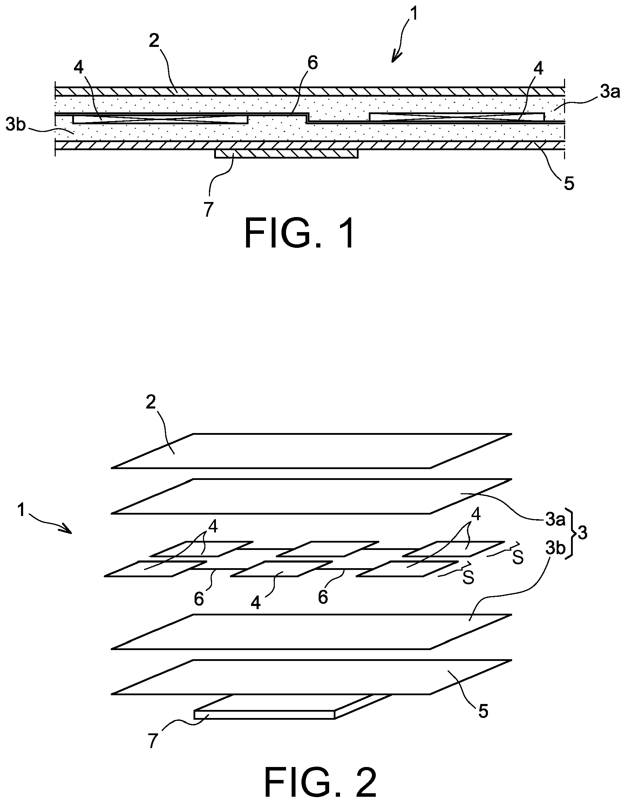

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une feuille polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement entre elles par des conducteurs de liaison 6 et immergées entre deux couches avant 3a et arrière 3b de matériau d'encapsulation formant toutes les deux un ensemble encapsulant 3.

Par ailleurs, les figures 1 et 2 représentent également la boîte de jonction 7 du module photovoltaïque 1, destinée à recevoir le câblage nécessaire à l'exploitation du module et raccordant les bandes de cuivre du circuit de cellules photovoltaïques. Classiquement, cette boîte de jonction 7 est réalisée en plastique ou en caoutchouc, et présente une étanchéité complète. Enfin, bien que non représenté sur les figures 1 et 2, un cadre en aluminium est prévu autour de l'ensemble des couches décrites auparavant pour finaliser le module photovoltaïque.

Ainsi, un module photovoltaïque comprend une multitude de cellules photovoltaïques identiques connectées en série et/ou en parallèle afin de fournir en sortie la tension et/ou le courant requis pour alimenter des dispositifs électriques. Le format de module le plus courant emploie 60 cellules carrées, ou « pseudo-carrées », de 156 mm de côté, réparties en six chaînes ou séries S, comme visible sur la figure 2, appelées encore « strings » selon la dénomination anglaise, de dix cellules interconnectées en série. Les six chaînes de cellules photovoltaïques sont également interconnectées en série.

Les porteurs de charge photogénérés, qui contribuent au courant électrique de la cellule photovoltaïque, sont collectés grâce à un réseau d'électrodes déposé sur la face avant de la cellule. Ces électrodes, appelées également doigts de collecte, sont étroites, typiquement de dimension inférieure à 100 µm. Elles sont généralement formées par sérigraphie d'une pâte contenant de l'argent. La face arrière de la cellule est soit recouverte d'un autre réseau d'électrodes (cas des cellules bifaciales), soit d'une couche métallique pleine, par exemple en aluminium (cas des cellules monofaciales). Le courant électrique circule ensuite d'une cellule à l'autre de la chaîne par des interconnexions.

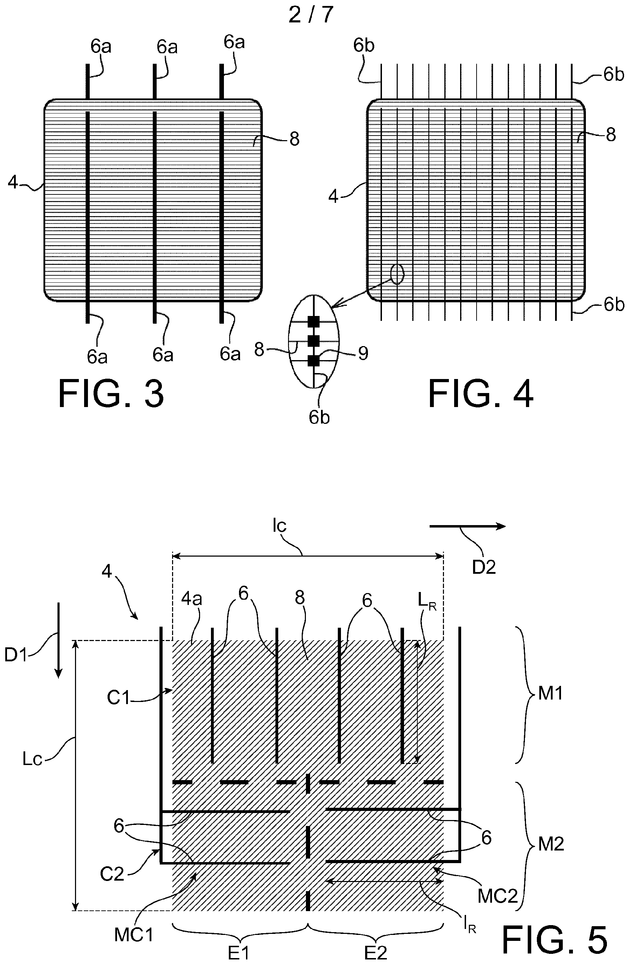

La présente invention est ainsi concernée par l'interconnexion des cellules photovoltaïques. On distingue classiquement deux techniques majeures pour interconnecter les cellules photovoltaïques d'une chaîne : les interconnexions en forme de ruban et les interconnexions en forme de fil électrique. Ces deux techniques sont respectivement représentées par les figures 3 et 4.

Sur la figure 3, les interconnexions entre les cellules 4 sont constituées de rubans 6a en cuivre recouverts d'un alliage fusible, typiquement un alliage d'étain et de plomb ou un alliage d'étain et d'argent. Ces rubans 6a de section rectangulaire sont soudés sur des pistes conductrices appelées « busbars » et formées en même temps que les doigts de collecte 8 par sérigraphie. Les busbars relient électriquement les doigts de collecte 8 et sont orientés perpendiculairement aux doigts de collecte 8.

Une cellule de 156 mm x 156 mm compte généralement trois rubans de 1,5 mm de large ou quatre rubans de 1,2 mm de large, ces rubans ayant une épaisseur de l'ordre de 0,2 mm. Chaque ruban 6a connecte la face avant d'une cellule 4 à la face arrière de la cellule 4 suivante dans la chaîne (non représentée sur la figure 3). La mise en série des cellules photovoltaïques 4 au moyen des rubans 6a s'effectue de façon entièrement automatisée, dans un équipement appelé « stringer ».

Plusieurs équipementiers proposent dorénavant de remplacer les rubans de cuivre par des fils électriques de plus faible section. Par exemple, la technologie « Multi-Busbar» développée par la société « Schmid » et décrite dans l'article « Multi-busbar solar cells and modules : high efficiencies and low silver consumption », S. Braun et al., Energy Procedia, vol. 38, pp. 334-339, 2013, multiplie le nombre de busbars déposés sur la cellule, passant de trois à quinze busbars, et soude à chaque busbar un fil de 200 µm de diamètre. Cette technologie est schématisée sur la figure 4. Les fils 6b sont constitués de cuivre et recouverts d'une fine couche d'un alliage à base d'étain-plomb ou d'étain-argent dont le point de fusion est situé au-dessus de 170°C. Les busbars ont une forme discontinue. Ils se composent de plots de métallisation 9, d'environ 500 µm x 700 µm, alignés sur les doigts de collecte 8. Les plots de métallisation 9 et les doigts de collecte 8 sont généralement réalisés par sérigraphie d'une pâte d'argent. La soudure des fils 6b sur les plots 9 a lieu immédiatement après avoir posé les fils 6b sur les plots 8, dans le même équipement, en chauffant ces éléments à une température de l'ordre de 200°C. Ainsi, l'alliage recouvrant les fils 6b de cuivre est fondu.

Les interconnexions en forme de fil électrique permettent de réduire la longueur des doigts de collecte par rapport à la configuration à trois busbars (voir la figure 3), car le nombre de fils est plus important que le nombre de rubans. Cette augmentation du nombre d'interconnexions n'a pas nécessairement d'impact sur l'ombrage de la cellule photovoltaïque en raison de la plus petite taille des fils. Par contre, elle permet de réduire considérablement la quantité d'argent utilisée pour imprimer les doigts de collecte. En effet, les doigts de collecte étant moins longs, on peut soit réduire la largeur des doigts, soit utiliser une pâte moins riche en argent, et donc moins conductrice, pour une résistance série équivalente. En outre, grâce à leur section circulaire, les fils électriques ont un ombrage effectif sur la cellule photovoltaïque égal à 70 % seulement de leur diamètre, contre 100 % de la largeur des rubans. Ainsi, pour un ensemble d'interconnexions ayant une même section transversales, le taux d'ombrage sur des cellules interconnectées par fils est plus faible que celui sur des cellules interconnectées par rubans.

Les doigts de collecte sont à l'origine de pertes résistives qui détériorent le facteur de forme (ou FF pour « Fill Factor » en anglais) de la cellule photovoltaïque, et donc son rendement. A ces pertes résistives au niveau de la cellule, il faut ajouter les pertes résistives au niveau du module, i.e. dans les interconnexions. Les pertes résistives dans les interconnexions sont proportionnelles au carré du courant électrique généré par le module et à la résistance série des interconnexions, qui dépend notamment de la section de cuivre utilisée.

Une solution pour diminuer ces pertes résistives consisterait donc à augmenter la section des rubans ou des fils de cuivre pour diminuer leur résistance série. Toutefois, cette solution est rarement mise en oeuvre en raison de deux inconvénients majeurs. Augmenter la section de cuivre, notamment via son épaisseur, entraînerait une augmentation des contraintes mécaniques dans les interconnexions, dues à la différence des coefficients de dilatation thermique entre le cuivre et le silicium, ce qui nuirait à la fiabilité des modules. De plus, l'augmentation de la section de cuivre via sa largeur aurait un impact négatif sur le taux d'ombrage des cellules photovoltaïques.

Il existe ainsi un besoin pour proposer une solution alternative d'interconnexion visant à améliorer la distribution du courant électrique et donc à réduire les pertes électriques.

### EXPOSÉ DE L'INVENTION

L'invention a pour but de remédier au moins partiellement aux besoins mentionnés précédemment et aux inconvénients relatifs aux réalisations de l'art antérieur.

L'invention a ainsi pour objet, selon l'un de ses aspects, un module photovoltaïque comportant :
- une première couche transparente formant la face avant du module photovoltaïque, destinée à recevoir un flux lumineux,
- une pluralité de cellules photovoltaïques disposées côte à côte et interconnectées électriquement entre elles par des éléments d'interconnexion, notamment sous forme de rubans, notamment des rubans de cuivre étamé, notamment respectivement disposés contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques,
- un ensemble encapsulant la pluralité de cellules photovoltaïques,
- une deuxième couche formant la face arrière du module photovoltaïque, l'ensemble encapsulant et la pluralité de cellules photovoltaïques étant situés entre les première et deuxième couches,
caractérisé en ce que chaque cellule photovoltaïque comporte, sur au moins l'une de ses faces avant et arrière, notamment sur chacune de ses faces avant et arrière, un nombre pair d'éléments d'interconnexion dont la longueur au contact de la cellule photovoltaïque est inférieure aux dimensions, notamment la longueur et la largeur, de la cellule photovoltaïque, en ce qu'une première moitié des éléments d'interconnexion comprend des éléments d'interconnexion sensiblement parallèles entre eux, et en ce qu'une deuxième moitié des éléments d'interconnexion comprend des éléments d'interconnexion sensiblement parallèles entre eux.

De façon avantageuse, chaque cellule photovoltaïque peut être apte à être interconnectée à une autre cellule photovoltaïque par le biais d'éléments d'interconnexion interconnectés entre eux par le biais d'éléments d'interconnexion de regroupement disposés de part et d'autre de la cellule photovoltaïque.

Selon une première variante, la première moitié des éléments d'interconnexion peut comprendre des éléments d'interconnexion s'étendant selon une première direction, notamment selon la longueur de chaque cellule photovoltaïque, et la deuxième moitié des éléments d'interconnexion peut comprendre des éléments d'interconnexion s'étendant selon une deuxième direction, notamment selon la largeur de chaque cellule photovoltaïque, les première et deuxième directions étant notamment sensiblement perpendiculaires entre elles.

Selon une deuxième variante, la première moitié des éléments d'interconnexion peut comprendre des éléments d'interconnexion s'étendant selon une direction prédéterminée, notamment selon la largeur de chaque cellule photovoltaïque, et la deuxième moitié des éléments d'interconnexion peut comprendre des éléments d'interconnexion s'étendant selon cette même direction prédéterminée, notamment selon la largeur de chaque cellule photovoltaïque, les éléments d'interconnexion étant ainsi tous sensiblement parallèles entre eux.

Le terme « transparent » signifie que le matériau de la première couche formant la face avant du module photovoltaïque est au moins partiellement transparent à la lumière visible, laissant passer au moins environ 80 % de cette lumière.

En outre, par le terme « encapsulant », il faut comprendre que la pluralité de cellules photovoltaïques est disposée dans un volume, par exemple hermétiquement clos vis-à-vis des liquides, au moins en partie formé par au moins une couche composée d'un matériau polymère dit d'encapsulation. En général, on utilise au moins deux couches d'encapsulation disposées de part et d'autre des cellules photovoltaïques et réunies entre elles après assemblage, notamment par lamination, pour former l'ensemble encapsulant les cellules. Ainsi, initialement, c'est-à-dire avant toute opération d'assemblage, l'ensemble encapsulant peut être constitué par au moins deux couches de matériau d'encapsulation, dites couches de coeur, entre lesquelles la pluralité de cellules photovoltaïques est encapsulée. Toutefois, pendant l'opération d'assemblage, le ou les matériaux d'encapsulation fondent pour ne former, après l'opération d'assemblage, qu'une seule couche (ou ensemble) solidifiée dans laquelle sont noyées ou encapsulées les cellules photovoltaïques.

Le module photovoltaïque selon l'invention peut en outre comporter l'une ou plusieurs des caractéristiques suivantes prises isolément ou suivant toutes combinaisons techniques possibles.

Pour chaque cellule photovoltaïque, les éléments d'interconnexion peuvent présenter sensiblement la même longueur au contact de la cellule photovoltaïque.

De plus, pour chaque cellule photovoltaïque, la longueur au contact de la cellule photovoltaïque des éléments d'interconnexion peut être inférieure à la moitié de la largeur et/ou de la longueur d'une cellule photovoltaïque, notamment égale à la moitié de la largeur et/ou de la longueur d'une cellule photovoltaïque diminuée de 2 à 6 mm.

En outre, pour chaque cellule photovoltaïque, la première moitié d'éléments d'interconnexion peut être située sur une première moitié de la cellule photovoltaïque, et la deuxième moitié d'éléments d'interconnexion peut être située sur une deuxième moitié de la cellule photovoltaïque.

De plus, pour chacune des première et deuxième moitiés des éléments d'interconnexion, les éléments d'interconnexion peuvent être équidistants les uns des autres.

Par ailleurs, selon la première variante de l'invention, pour chaque cellule photovoltaïque, la première moitié des éléments d'interconnexion peut comprendre des éléments d'interconnexion, situés sur la première moitié de la cellule photovoltaïque, s'étendant verticalement selon la première direction d'un bord à l'autre de la cellule photovoltaïque, et la deuxième moitié des éléments d'interconnexion peut comprendre des éléments d'interconnexion s'étendant horizontalement selon la deuxième direction d'un bord à l'autre de la cellule photovoltaïque, ceux-ci pouvant être répartis en un premier ensemble d'éléments d'interconnexion sur une première moitié de la deuxième moitié de la cellule photovoltaïque et un deuxième ensemble d'éléments d'interconnexion sur une deuxième moitié de la deuxième moitié de la cellule photovoltaïque, les premier et deuxième ensembles étant espacés l'un de l'autre, chaque élément d'interconnexion du premier ensemble étant notamment sensiblement aligné selon la deuxième direction avec un élément d'interconnexion du deuxième ensemble.

Les éléments d'interconnexion peuvent en outre avantageusement ne pas être superposés les uns aux autres.

La largeur des éléments d'interconnexion peut être comprise entre 0,5 et 2,5 mm. L'épaisseur des éléments d'interconnexion peut être comprise entre 0,05 et 0,6 mm.

En outre, le module photovoltaïque peut comporter des première et deuxième cellules photovoltaïques interconnectées entre elles par le biais d'éléments d'interconnexion, de sorte que les éléments d'interconnexion de la face arrière de la première cellule photovoltaïque, notamment ceux s'étendant selon la deuxième direction, peuvent être interconnectés aux éléments d'interconnexion de la face avant de la deuxième cellule photovoltaïque, notamment ceux s'étendant selon la deuxième direction, par le biais d'éléments d'interconnexion de regroupement de chaque côté des cellules photovoltaïques.

Chaque élément d'interconnexion de regroupement peut comporter, notamment sur sa surface destinée à être au contact des éléments d'interconnexion de la face arrière de la première cellule photovoltaïque, notamment ceux s'étendant selon la deuxième direction, un élément adhésif isolant, notamment un ruban adhésif isolant.

La largeur des éléments d'interconnexion de regroupement peut être comprise entre 0,5 et 20 mm. L'épaisseur des éléments d'interconnexion de regroupement peut être comprise entre 0,05 et 1 mm.

De plus, les éléments d'interconnexion peuvent être solidarisés, notamment par soudure, à des pistes conductrices dénommées « busbars » reliant électriquement des doigts de collecte, les pistes conductrices et les doigts de collecte étant formés par sérigraphie sur chaque cellule photovoltaïque.

Les doigts de collecte peuvent avantageusement être disposés de façon sensiblement parallèle à une diagonale de la cellule photovoltaïque, autrement dit un segment reliant deux coins opposés de la cellule photovoltaïque, celle-ci étant préférentiellement de forme polygonale, et notamment carrée ou rectangulaire. En variante, les doigts de collecte peuvent être disposés selon une première direction sur une première moitié de la cellule photovoltaïque et selon une deuxième direction sur une deuxième moitié de la cellule photovoltaïque.

En outre, l'invention a encore pour objet, selon un autre de ses aspects, un procédé d'interconnexion électrique de cellules photovoltaïques d'un module photovoltaïque, notamment un module photovoltaïque tel que défini précédemment, par des éléments d'interconnexion, notamment sous forme de rubans, notamment des rubans de cuivre étamé, notamment respectivement disposés contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques,
caractérisé en ce que, pour un nombre entier N supérieur ou égal à 2 d'éléments d'interconnexion nécessaire par cellule photovoltaïque présentant chacun une même longueur de base, le procédé comporte l'étape d'utilisation de 2 x N éléments d'interconnexion par cellule photovoltaïque présentant chacun une longueur égale à la moitié de ladite longueur de base, et en ce qu'une première moitié des 2 x N éléments d'interconnexion comprend des éléments d'interconnexion sensiblement parallèles entre eux, et qu'une deuxième moitié des 2 x N éléments d'interconnexion comprend des éléments d'interconnexion sensiblement parallèles entre eux.

Selon une première variante, la première moitié des 2 x N éléments d'interconnexion peut comprendre des éléments d'interconnexion s'étendant selon une première direction, notamment selon la longueur de chaque cellule photovoltaïque, et la deuxième moitié des 2 x N éléments d'interconnexion peut comprendre des éléments d'interconnexion s'étendant selon une deuxième direction, notamment selon la largeur de chaque cellule photovoltaïque, les première et deuxième directions étant notamment sensiblement perpendiculaires entre elles.

Selon une deuxième variante, la première moitié des 2 x N éléments d'interconnexion peut comprendre des éléments d'interconnexion s'étendant selon une direction prédéterminée, notamment selon la largeur de chaque cellule photovoltaïque, et la deuxième moitié des 2 x N éléments d'interconnexion peut comprendre des éléments d'interconnexion s'étendant selon cette même direction prédéterminée, notamment selon la largeur de chaque cellule photovoltaïque, les éléments d'interconnexion étant ainsi tous sensiblement parallèles entre eux.

L'invention a également pour objet, selon un autre de ses aspects, un procédé de fabrication d'un module photovoltaïque tel que défini précédemment, caractérisé en ce que les cellules photovoltaïques sont recouvertes d'une couche de sérigraphie comprenant des doigts de collecte et des pistes conductrices dénommées « busbars » solidarisées, notamment par soudure, aux éléments d'interconnexion, la sérigraphie étant réalisée en au moins deux étapes comprenant respectivement la réalisation des doigts de collecte à l'aide d'un écran pour doigts de collecte, et la réalisation des pistes conductrices à l'aide d'un écran pour pistes conductrices.

Les doigts de collecte peuvent être formés par sérigraphie de sorte à être orientés de façon parallèle à une diagonale de la cellule photovoltaïque. En variante, les doigts de collecte peuvent être formés par sérigraphie de sorte à être orientés selon la première direction sur une deuxième moitié de la cellule photovoltaïque et selon la deuxième direction sur une première moitié de la cellule photovoltaïque.

L'ensemble encapsulant peut notamment être réalisé à partir d'au moins un matériau polymère choisi parmi : le poly(éthylène-acétate de vinyle) (EVA), les ionomères, les polyoléfines, les acétals de vinyle, tels que les polyvinylbutyrals (PVB), les chlorures de polyvinyle (PVC), les polydiméthylsiloxanes, les polyuréthanes (PU) ou encore le polyméthacrylate de méthyle (PMMA), l'éthylène-acrylate de méthyle (EMA), le butylacrylate d'éthylène (EBA), l'éthylène-propylène (EPM/EPDM).

L'ensemble encapsulant peut préférentiellement être réalisé à partir de deux couches de poly(éthylène-acétate de vinyle) (EVA) entre lesquelles sont disposées les cellules photovoltaïques.

La première couche peut être réalisée en verre, ou encore en au moins un matériau polymère, tel que le polyméthacrylate de méthyle (PMMA), le polycarbonate (PC), des fibres de verre ou de carbone imprégnées, entre autres. La deuxième couche peut être réalisée en verre, en métal ou encore en au moins un matériau polymère tel que le polyméthacrylate de méthyle (PMMA), le polycarbonate (PC), des fibres de verre ou de carbone imprégnées, entre autres.

Les cellules photovoltaïques peuvent être choisies parmi : des cellules photovoltaïques homojonction ou hétérojonction à base de silicium monocristallin (c-Si) et/ou multi-cristallin (mc-Si), et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS), entre autres. Par ailleurs, les cellules photovoltaïques peuvent présenter une épaisseur comprise entre 1 et 300 µm.

Le module photovoltaïque peut en outre comporter une boîte de jonction, destinée à recevoir le câblage nécessaire à l'exploitation du module photovoltaïque.

Par ailleurs, quand bien même la première couche formant la face avant du module photovoltaïque est transparente, la deuxième couche formant la face arrière du module photovoltaïque peut être ou non transparente, étant notamment opaque.

Le module photovoltaïque, le procédé d'interconnexion et le procédé de fabrication selon l'invention peuvent comporter l'une quelconque des caractéristiques précédemment énoncées, prises isolément ou selon toutes combinaisons techniquement possibles avec d'autres caractéristiques.

### BRÈVE DESCRIPTION DES DESSINS

L'invention pourra être mieux comprise à la lecture de la description détaillée qui va suivre, d'exemples de mise en oeuvre non limitatifs de celle-ci, ainsi qu'à l'examen des figures, schématiques et partielles, du dessin annexé, sur lequel :
- la figure 1 représente, en coupe, un exemple classique de module photovoltaïque comportant des cellules photovoltaïques cristallines,
- la figure 2 représente, en vue éclatée, le module photovoltaïque de la figure 1,
- les figures 3 et 4 représentent schématiquement deux techniques d'interconnexion de cellules photovoltaïques selon l'art antérieur,
- les figures 5 et 6 représentent schématiquement et respectivement la face avant et la face arrière d'une cellule photovoltaïque d'un module photovoltaïque conforme à l'invention,
- la figure 7 illustre schématiquement l'interconnexion entre deux cellules photovoltaïques d'un module photovoltaïque conforme à l'invention,
- la figure 8 est une vue partielle latérale selon VII de la figure 7,
- la figure 9 est une vue semblable à celle de la figure 7 illustrant une variante de réalisation de l'invention,
- la figure 10 est un graphique représentant la puissance maximale, exprimée en Watts, obtenue pour des cellules photovoltaïques de référence et des cellules photovoltaïques conformes à l'invention,
- la figure 11 est un graphique représentant la puissance maximale, exprimée en Watts, obtenue pour des modules photovoltaïques de référence à une cellule et des modules photovoltaïques à une cellule conformes à l'invention,
- les figures 12 et 13 illustrent, respectivement, un premier et un deuxième motifs possibles de sérigraphie pour la formation de doigt de collecte pour une cellule photovoltaïque d'un module photovoltaïque conforme à l'invention,
- les figures 14 à 17 illustrent par ailleurs les étapes de réalisation d'une alternative de création du motif de sérigraphie de la figure 12,
- les figures 18 et 19 illustrent respectivement la face avant et la face arrière de la cellule photovoltaïque comprenant les éléments d'interconnexion en utilisant le motif de sérigraphie de la figure 12, et
- les figures 20 et 21 illustrent respectivement la face avant et la face arrière de la cellule photovoltaïque comprenant les éléments d'interconnexion en utilisant le motif de sérigraphie de la figure 13.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Les figures 1 à 4 ont déjà été décrites dans la partie relative à l'état de la technique antérieure et au contexte technique de l'invention.

De plus, il est à noter qu'un module photovoltaïque 1 conforme à l'invention peut comporter des couches constitutives semblables à celles décrites en référence aux figures 1 et 2, lesquelles ne sont donc pas nécessairement décrites de nouveau.

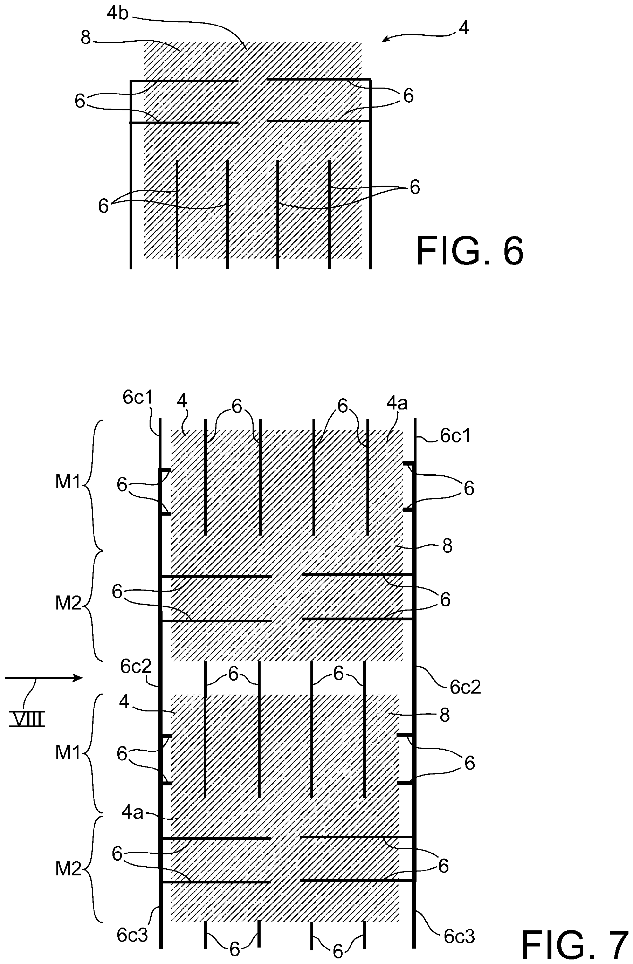

En référence aux figures 5 et 6, on a représenté respectivement la face avant 4a et la face arrière 4b d'une cellule photovoltaïque 4 d'un module photovoltaïque 1 conforme à l'invention.

Ainsi, la cellule photovoltaïque 4 comporte des éléments d'interconnexion 6 sous forme de rubans pour son interconnexion avec les autres cellules 4 du module photovoltaïque 1. Ces rubans 6 sont notamment des rubans de cuivre étamé, respectivement disposés contre les faces avant 4a (face se trouvant en regard de la face avant du module photovoltaïque 1 destinée à recevoir un flux lumineux) et arrière 4b (face se trouvant en regard de la face arrière du module photovoltaïque 1) de chacune des cellules photovoltaïques 4.

De façon habituelle, selon un procédé de l'art antérieur, tous les rubans 6 seraient parallèles les uns aux autres, avec un nombre entier N de rubans d'au moins 2, voire 3, voire 4, voire plus, par face d'une cellule photovoltaïque 4. Par exemple, sur l'exemple de la figure 3, la cellule photovoltaïque 4 comporte trois rubans 6a par face.

De façon avantageuse, l'invention propose d'utiliser deux fois plus de rubans 6, soit un nombre 2 x N de rubans 6, ceux-ci étant de moitié moins longs. Autrement dit, chaque ruban 6 qui serait utilisé dans l'art antérieur est divisé en deux de sorte que deux fois plus de rubans 6 moins longs sont utilisés par face de la cellule photovoltaïque 4.

Plus précisément, chaque cellule photovoltaïque 4 comporte ainsi un nombre pair de rubans 6 dont la longueur I_{R} au contact de la cellule photovoltaïque 4 est inférieure aux dimensions, notamment la longueur et la largeur, de la cellule photovoltaïque 4.

En conséquence, l'ombrage reste identique car il subsiste une même longueur globale de rubans 6 à ombrager la cellule 4. Cela permet avantageusement de réduire les pertes résistives du fait de la division du courant électrique.

Plus particulièrement, dans l'exemple des figures 5 et 6, on utilise huit demi-rubans 6 par face de la cellule photovoltaïque 4 alors que l'art antérieur aurait utilisé quatre rubans 6 par face de la cellule photovoltaïque 4. Ainsi, le courant électrique est divisé par huit au lieu de quatre. Cela entraîne une diminution des pertes résistives.

Par ailleurs, comme visible sur les figures 5 et 6, la disposition des rubans 6 diffère dans l'invention par rapport à l'art antérieur pour lequel tous les rubans sont habituellement disposés de sorte à être tous parallèles entre eux.

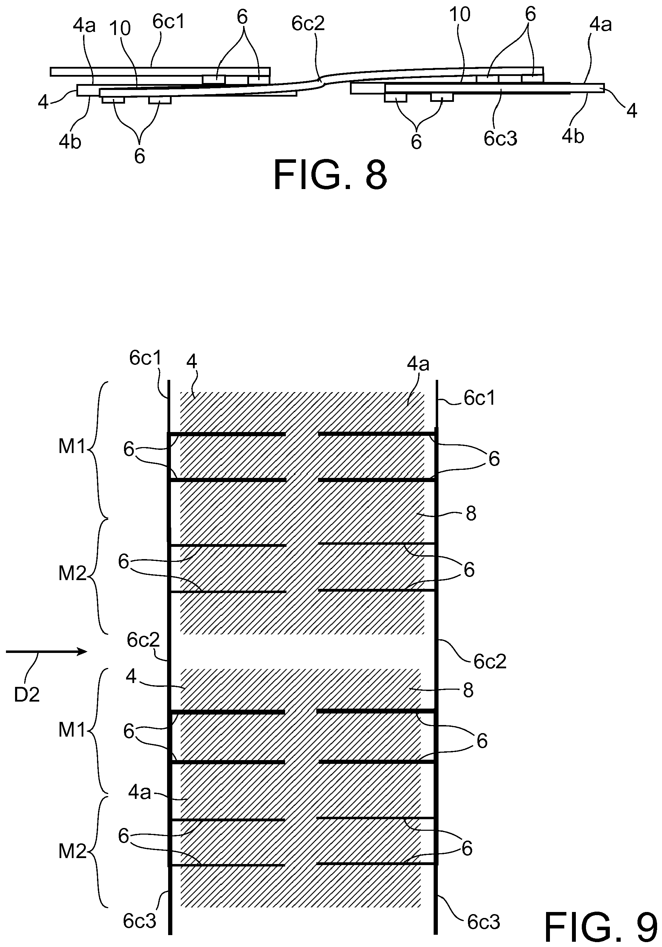

Dans le cadre de l'invention, une première moitié M1 des rubans 6 comprend des rubans 6 parallèles entre eux et s'étendant selon une première direction D1 selon la longueur de chaque cellule photovoltaïque 4. De plus, une deuxième moitié M2 des rubans 6 comprend des rubans 6 parallèles entre eux et s'étendant selon une deuxième direction D2 selon la largeur de chaque cellule photovoltaïque 4. Les première D1 et deuxième D2 directions sont perpendiculaires entre elles de sorte que la première moitié M1 de rubans 6 est globalement perpendiculaire à la deuxième moitié M2 de rubans 6. Il est à noter que, selon une variante de l'invention, la première moitié M1 de rubans 6 est globalement parallèle à la deuxième moitié M2 de rubans 6, comme il sera décrit par la suite en référence à la figure 9.

Autrement dit, sur la figure 5 par exemple, quatre rubans 6 sont horizontaux tandis que quatre rubans 6 sont verticaux. Les rubans 6 ne se croisent pas. Il est donc possible de réduire les pertes résistives sans ombrager davantage les cellules photovoltaïques 4.

Par ailleurs, il est à noter que, pour chaque cellule photovoltaïque 4, les rubans 6 présentent sensiblement la même longueur I_{R} au contact de la cellule photovoltaïque 4. Les rubans 6 peuvent avoir une largeur comprise par exemple entre 0,5 et 2,5 mm, et une épaisseur comprise par exemple entre 0,05 et 0,6 mm.

En outre, pour les rubans 6 de la première moitié M1, la longueur I_{R} au contact de la cellule photovoltaïque 4 des rubans 6 est inférieure à la moitié de la largeur I_{C} de la cellule photovoltaïque 4. Plus précisément, la longueur I_{R} est par exemple égale à la moitié de la largeur I_{C} de la cellule photovoltaïque 4 diminuée de 2 à 6 mm.

De même, pour les rubans 6 de la deuxième moitié M2, la longueur I_{R} au contact de la cellule photovoltaïque 4 des rubans 6 est inférieure à la moitié de la longueur L_{C} de la cellule photovoltaïque 4. Plus précisément, la longueur I_{R} est par exemple égale à la moitié de la longueur L_{C} de la cellule photovoltaïque 4 diminuée de 2 à 6 mm.

En outre, comme signifié sur la figure 5, la première moitié M1 des rubans 6 est située sur une première moitié C1 de la cellule photovoltaïque 4, et la deuxième moitié M2 des rubans 6 est située sur une deuxième moitié C2 de la cellule photovoltaïque 4. Il apparaît également que, pour chacune des première M1 et deuxième M2 moitiés des rubans 6, les rubans 6 sont équidistants les uns des autres.

De façon plus précise encore, la figure 5 illustre le fait que la première moitié M1 des rubans 6 comprend des rubans 6, situés sur la première moitié C1 de la cellule photovoltaïque 4, s'étendant verticalement selon la première direction D1 d'un bord à l'autre de la cellule photovoltaïque 4, et le fait que la deuxième moitié M2 des rubans 6 comprend des rubans 6 s'étendant horizontalement selon la deuxième direction D2 d'un bord à l'autre de la cellule photovoltaïque 4, étant répartis en un premier ensemble E1 de rubans 6 sur une première moitié MC1 de la deuxième moitié C2 de la cellule photovoltaïque 4 et un deuxième ensemble E2 de rubans 6 sur une deuxième moitié MC2 de la deuxième moitié C2 de la cellule photovoltaïque 4.

Les premier E1 et deuxième E2 ensembles sont espacés l'un de l'autre, chaque ruban 6 du premier ensemble E1 étant sensiblement aligné selon la deuxième direction

D2 avec un ruban 6 du deuxième ensemble E2. Autrement dit, les rubans 6 horizontaux sont disposés face à face.

On a maintenant illustré sur la figure 7 l'interconnexion entre deux cellules photovoltaïques 4 d'un module photovoltaïque 1 conforme à l'invention. De plus, la figure 8 est une vue partielle de côté, selon VII, de la figure 7, permettant de mieux visualiser l'interconnexion des deux cellules 4 avec leur face avant 4a et leur face arrière 4b.

Chaque cellule photovoltaïque 4 est semblable à celle décrite en référence aux figures 5 et 6. Les figures 7 et 8 permettent de mieux décrire l'interconnexion des rubans 6 horizontaux présents sur chaque face avant 4a et chaque face arrière 4b des cellules 4.

Plus précisément, la première cellule photovoltaïque 4, en haut sur la figure 7, comporte, sur sa face avant 4a, des rubans verticaux 6 dans la première moitié M1 et des rubans horizontaux 6 dans la deuxième moitié M2. La première cellule photovoltaïque 4 comporte par ailleurs, sur sa face arrière 4b, des rubans horizontaux 6 dans la première moitié M1 et des rubans verticaux 6 dans la deuxième moitié M2.

De même, la deuxième cellule photovoltaïque 4, en bas sur la figure 7, comporte, sur sa face avant 4a, des rubans verticaux 6 dans la première moitié M1 et des rubans horizontaux 6 dans la deuxième moitié M2. La première cellule photovoltaïque 4 comporte par ailleurs, sur sa face arrière 4b, des rubans horizontaux 6 dans la première moitié M1 et des rubans verticaux 6 dans la deuxième moitié M2.

Les rubans horizontaux 6 de la face arrière 4b de la première cellule 4 sont interconnectés avec les rubans horizontaux 6 de la face avant 4a de la deuxième cellule 4. Cette interconnexion est réalisée par le biais de rubans de regroupement 6c2 tels que visibles sur les figures 7 et 8. Ces rubans de regroupement 6c2 permettent de relier électriquement les rubans horizontaux 6 de la face arrière 4b de la première cellule 4 et de la face avant 4a de la deuxième cellule 4.

Il est à noter que les figures 7 et 8 permettent aussi de visualiser les rubans de regroupement 6c1 permettant l'interconnexion électrique entres les rubans horizontaux 6 de la face avant 4a de la première cellule 4 et les rubans horizontaux de la face arrière 4b d'une autre cellule 4 non représentée mais qui se situerait, sur la figure 7, au-dessus de la première cellule 4, et également les rubans de regroupement 6c3 permettant l'interconnexion électrique entres les rubans horizontaux 6 de la face arrière 4b de la deuxième cellule 4 et les rubans horizontaux de la face avant 4a d'une autre cellule 4 non représentée mais qui se situerait, sur la figure 7, au-dessous de la deuxième cellule 4.

Afin de permettre l'interconnexion des rubans horizontaux 6 de la face arrière 4b de la première cellule 4 avec les rubans horizontaux 6 de la face avant 4a de la deuxième cellule 4, les rubans de regroupement 6c2 comportent des rubans adhésifs isolants 10. Plus précisément, comme visible sur la figure 8, le ruban de regroupement 6c2 comporte sur sa face supérieure au niveau de la première cellule 4 un ruban adhésif isolant 10. De même, le ruban de regroupement 6c3 comporte sur sa face supérieure au niveau de la deuxième cellule 4 un ruban adhésif isolant 10. Les rubans 6c1, 6c2 et 6c3 peuvent avoir une largeur comprise par exemple entre 0,5 et 20 mm, et une épaisseur comprise par exemple entre 0,05 et 1 mm.

Pour pourvoir réaliser une telle interconnexion des première et deuxième cellules photovoltaïques 4 représentées sur les figures 7 et 8, on peut tout d'abord coller ou souder l'ensemble des rubans 6 de la face arrière 4b de la première cellule 4. Puis, on peut coller un ruban adhésif isolant 10 sur la face supérieure des rubans de regroupement 6c2 au niveau de la première cellule 4.

Ensuite, il est possible de coller ou souder tous les rubans 6 de la face avant 4a de la première cellule 4. Puis, on peut coller ou souder tous les rubans 6 de la face arrière 4b de la deuxième cellule 4. Alors, il est possible de coller un ruban adhésif isolant 10 sur la face supérieur des rubans de regroupement 6c3 au niveau de la deuxième cellule 4. Enfin, un collage ou soudage de tous les rubans 6 de la face avant 4a de la deuxième cellule 4 peut être réalisé.

Par ailleurs, la figure 9 est une vue semblable à celle de la figure 7 illustrant une variante de réalisation de l'invention. Dans cette variante, pour une cellule photovoltaïque 4 donnée, la première moitié M1 de rubans 6 est globalement parallèle à la deuxième moitié M2 de rubans 6.

Plus précisément, pour une cellule photovoltaïque 4 donnée, une première moitié M1 des rubans 6 comprend des rubans 6 parallèles entre eux et s'étendant selon la deuxième direction D2 selon la largeur de la cellule photovoltaïque 4. De plus, une deuxième moitié M2 des rubans 6 comprend des rubans 6 parallèles entre eux et s'étendant également selon la deuxième direction D2. Aussi, la première moitié M1 de rubans 6 est globalement parallèle à la deuxième moitié M2 de rubans 6.

La figure 9 illustre en outre l'interconnexion entre deux cellules photovoltaïques 4 d'un module photovoltaïque 1 conforme à l'invention.

La première cellule photovoltaïque 4, en haut sur la figure 9, comporte, sur sa face avant 4a, des rubans horizontaux 6 dans la première moitié M1 et des rubans horizontaux 6 dans la deuxième moitié M2. La première cellule photovoltaïque 4 comporte par ailleurs, sur sa face arrière 4b, des rubans horizontaux 6 dans la première moitié M1 et des rubans horizontaux 6 dans la deuxième moitié M2.

De même, la deuxième cellule photovoltaïque 4, en bas sur la figure 9, comporte, sur sa face avant 4a, des rubans horizontaux 6 dans la première moitié M1 et des rubans horizontaux 6 dans la deuxième moitié M2. La première cellule photovoltaïque 4 comporte par ailleurs, sur sa face arrière 4b, des rubans horizontaux 6 dans la première moitié M1 et des rubans horinzontaux 6 dans la deuxième moitié M2.

Les rubans horizontaux 6 de la face arrière 4b de la première cellule 4 sont interconnectés avec les rubans horizontaux 6 de la face avant 4a de la deuxième cellule 4. Cette interconnexion est réalisée par le biais de rubans de regroupement 6c2 tels que visibles sur la figure 9. Ces rubans de regroupement 6c2 permettent de relier électriquement les rubans horizontaux 6 de la face arrière 4b de la première cellule 4 et de la face avant 4a de la deuxième cellule 4.

Il est à noter que la figure 9 permet aussi de visualiser les rubans de regroupement 6c1 permettant l'interconnexion électrique entres les rubans horizontaux 6 de la face avant 4a de la première cellule 4 et les rubans horizontaux de la face arrière 4b d'une autre cellule 4 non représentée mais qui se situerait, sur la figure 9, au-dessus de la première cellule 4, et également les rubans de regroupement 6c3 permettant l'interconnexion électrique entres les rubans horizontaux 6 de la face arrière 4b de la deuxième cellule 4 et les rubans horizontaux de la face avant 4a d'une autre cellule 4 non représentée mais qui se situerait, sur la figure 9, au-dessous de la deuxième cellule 4.

Afin de permettre l'interconnexion des rubans horizontaux 6 de la face arrière 4b de la première cellule 4 avec les rubans horizontaux 6 de la face avant 4a de la deuxième cellule 4, les rubans de regroupement 6c2 comportent des rubans adhésifs isolants 10, comme décrit précédemment en lien avec la figure 8.

Des essais de puissance obtenue ont été réalisés avec un module photovoltaïque de référence, tel que celui de la figure 3 selon l'art antérieur à ceci près que chaque cellule 4 comporte quatre rubans 6 parallèles, en comparaison avec un module photovoltaïque 1 pour lequel chaque cellule photovoltaïque 4 comporte deux ensembles E1 et E2 de deux rubans 6 horizontaux et quatre rubans 6 verticaux, tel que représenté sur la figure 5.

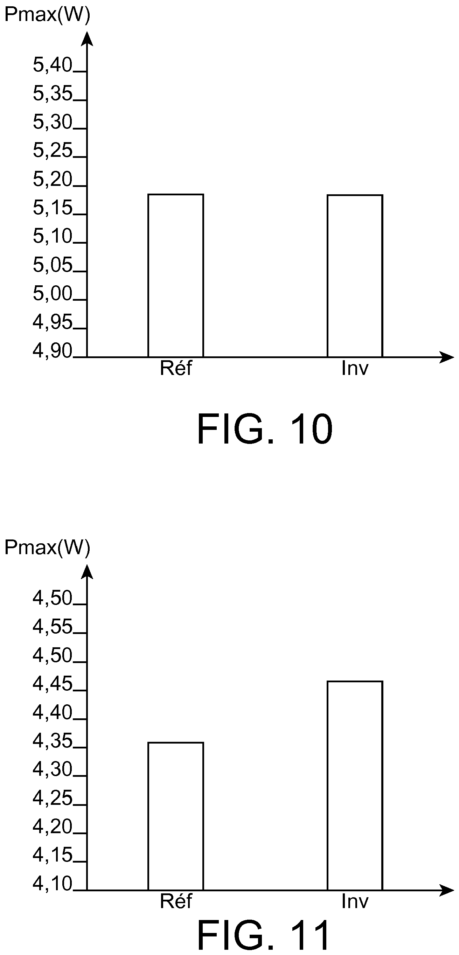

Le graphique de la figure 10 illustre la puissance maximale Pmax, exprimée en Watts (W), obtenue pour des cellules photovoltaïques de référence notées Réf et des cellules photovoltaïques conformes à l'invention notées Inv.

De plus, le graphique de la figure 11 illustre la puissance maximale Pmax, exprimée en Watts (W), obtenue pour des modules photovoltaïques de référence à une cellule notés Réf et des modules photovoltaïques à une cellule conformes à l'invention notés Inv.

On constate ainsi qu'un module photovoltaïque avec une interconnexion conforme au principe de l'invention montre une puissance maximale qui est plus élevée qu'un module de référence.

Par ailleurs, comme expliqué précédemment en référence à la figure 3, les rubans 6 sont préférentiellement soudés sur des pistes conductrices appelées « busbars » et formées en même temps que les doigts de collecte 8 par sérigraphie. Ces busbars relient électriquement les doigts de collecte 8.

Le choix du nombre de « demi-busbars » sur lesquels sont soudés les « demi-rubans » 6, ainsi que leurs dimensions, et également le choix du nombre et des dimensions des rubans 6 et 6c, influent sur la puissance délivrée par les cellules photovoltaïques 4.

Ainsi, les busbars peuvent par exemple présenter une largeur comprise entre 0,03 et 2,5 mm, ainsi qu'une épaisseur comprise par exemple entre 0,001 et 0,1 mm.

Les doigts de collecte 8 peuvent par exemple présenter une largeur comprise entre 0,01 et 0,2 mm, ainsi qu'une épaisseur par exemple comprise entre 0,001 et 0,1 mm.

Avantageusement, la sérigraphie peut être réalisée en deux temps, à savoir : réalisation des doigts de collecte 8 à l'aide d'un écran pour doigts de collecte ; puis réalisation des busbars à l'aide d'un écran pour busbars.

Comme décrit précédemment, le choix d'avoir une interconnexion avec des busbars orientés suivant les axes vertical et horizontal impose un motif particulier pour la sérigraphie des doigts de collecte 8 afin que ceux-ci puissent relier les busbars verticaux et les busbars horizontaux.

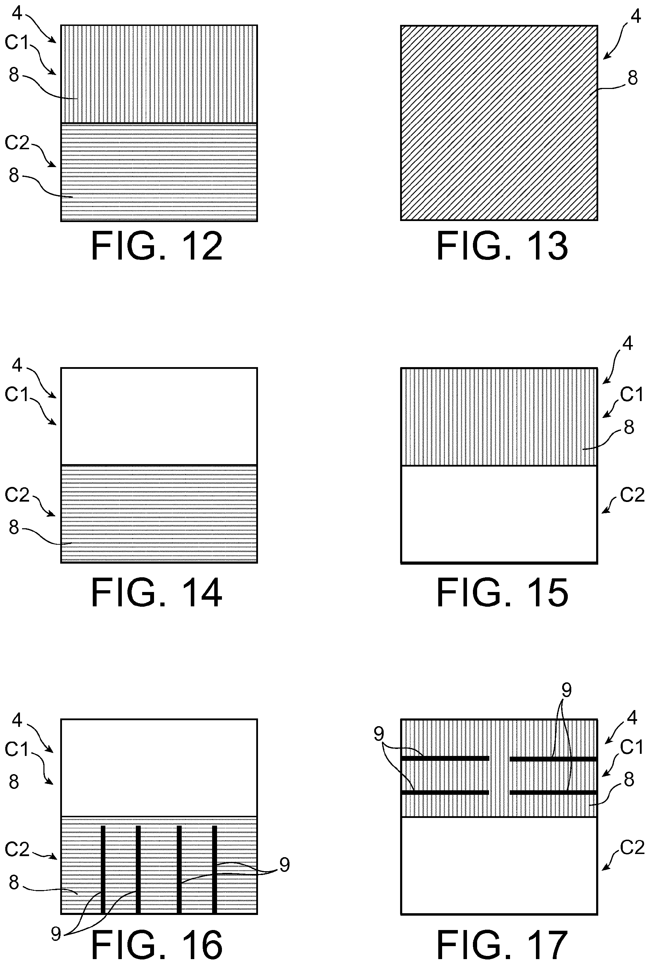

Les figures 12 et 13 illustrent ainsi, respectivement, un premier et un deuxième motifs possibles de sérigraphie pour la cellule 4 pour la formation des doigts de collecte 8.

Habituellement, les doigts de collecte 8 sont connectés à 90° des busbars. Conformément à l'invention, les doigts de collecte 8 peuvent être orientés à 45°, soit être parallèles à une diagonale de la cellule 4, comme visible sur la figure 13, ou bien encore les doigts de collecte 8 peuvent être orientés verticalement sur une première moitié C1 de la cellule 4 et horizontalement sur une deuxième moitié C2 de la cellule 4, comme visible sur la figure 12.

Il apparaît que le motif de la figure 13 est le plus simple à mettre en oeuvre car il ne nécessite qu'un seul masque ou écran de sérigraphie correspondant donc à une seule étape.

Le motif de la figure 12 pourrait également être obtenu en une seule étape mais il est préférable de conserver les doigts de collecte 8 dans le sens du raclage pour garantir une meilleure qualité (finesse, contrôle).

Les figures 14 à 17 illustrent par ailleurs une alternative de création du motif de sérigraphie de la figure 12.

Ainsi, le motif de la figure 12 peut être créé en deux étapes : impression des lignes horizontales dans une étape a1 (voir figure 14), puis impression des lignes verticales dans une étape a2 (voir figure 15), ou inversement, en utilisant une rotation à 90° entre les deux postes d'impression. Alors, les doigts de collecte 8 peuvent être bien sérigraphiés selon le sens de raclage. Par ailleurs, les figures 16 et 17 sont respectivement analogues aux figures 14 et 15 avec la présence des busbars 9. Ainsi, de façon préférentielle, la sérigraphie des busbars 9 est effectuée en deux étapes b1 et b2 : réalisation des busbars 9 verticaux (ou horizontaux) dans un premier temps à l'aide d'un premier masque, et dans un deuxième temps réalisation des busbars 9 restants horizontaux (ou verticaux) à l'aide d'un deuxième masque. Cette réalisation des busbars 9 en deux étapes permet de racler dans le sens de la longueur des busbars 9 et permet une meilleure impression.

La largeur des busbars 9 sérigraphiés peut par exemple être comprise entre 0,1 mm et 4 mm. Leur longueur est variable.

Il faut toutefois noter que, afin de réduire le nombre d'impressions par rapport à la configuration de la figure 13, il pourrait être envisagé de sérigraphier les busbars 9 et les doigts de collecte 8 en même temps.

Il faut en outre noter que, pour tous les exemples précédemment décrits, l'étape de sérigraphie est réalisée sur la face avant 4a et sur la face arrière 4b de la cellule photovoltaïque 4.

Au total, la sérigraphie se déroule donc en quatre étapes au minimum en configuration de la figure 12 selon les étapes visibles aux figures 14 à 17.

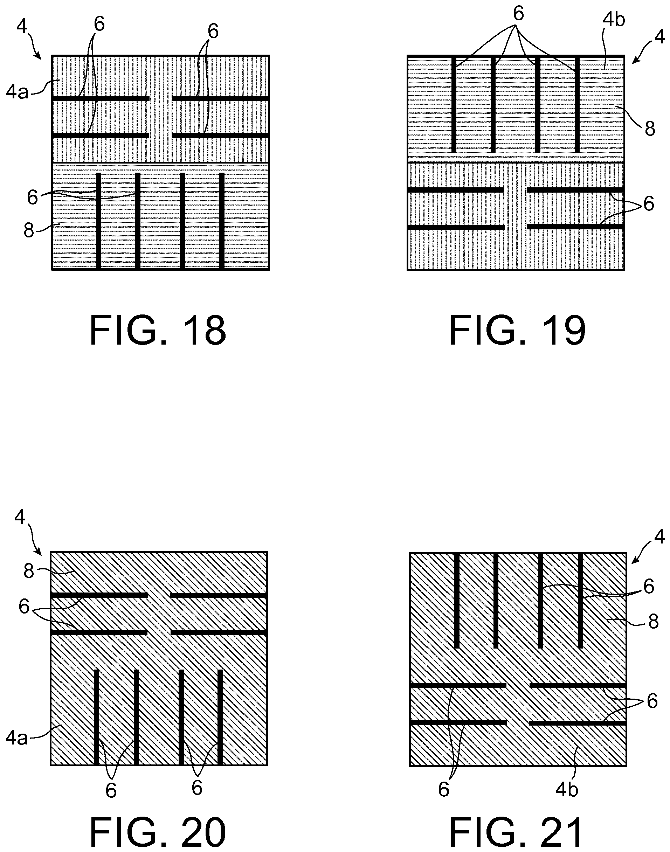

Les figures 18 et 19 illustrent par ailleurs respectivement la face avant 4a et la face arrière de la cellule photovoltaïque 4 comprenant les rubans 6 en utilisant le motif de sérigraphie de la figure 12.

De même, les figures 20 et 21 illustrent respectivement la face avant 4a et la face arrière 4b de la cellule photovoltaïque 4 comprenant les rubans 6 en utilisant le motif de sérigraphie de la figure 13.

Bien entendu, l'invention n'est pas limitée aux exemples de réalisation qui viennent d'être décrits. Diverses modifications peuvent y être apportées par l'homme du métier.

Par exemple, dans le cas d'une interconnexion monolithique, la face arrière 4b de la première cellule photovoltaïque 4 est interconnectée avec la face arrière 4b de la deuxième cellule photovoltaïque 4.

De plus, la sérigraphie permettant l'application des pistes conductrices, ou busbars, et des doigts de collecte pourrait être appliquée uniquement sur des demi-cellules photovoltaïques ou des quarts de cellules photovoltaïques.

De plus, la sérigraphie peut être bifaciale comme décrite précédemment ou encore monofaciale.

En outre, la sérigraphie pourrait le cas échéant être remplacée par de l'impression jet d'encre, de la distribution, du modelage ou encore du dépôt.

## Revendications

1. Module photovoltaïque (1) comportant :
- une première couche (2) transparente formant la face avant du module photovoltaïque (1), destinée à recevoir un flux lumineux,
- une pluralité de cellules photovoltaïques (4) disposées côte à côte et interconnectées électriquement entre elles par des éléments d'interconnexion (6),
- un ensemble encapsulant (3) la pluralité de cellules photovoltaïques (4),
- une deuxième couche (5) formant la face arrière du module photovoltaïque (1), l'ensemble encapsulant (3) et la pluralité de cellules photovoltaïques (4) étant situés entre les première (2) et deuxième (5) couches,
**caractérisé en ce que** chaque cellule photovoltaïque (4) comporte, sur au moins l'une de ses faces avant (4a) et arrière (4b), un nombre pair d'éléments d'interconnexion (6) dont la longueur (I_{R}) au contact de la cellule photovoltaïque (4) est inférieure aux dimensions de la cellule photovoltaïque (4), **en ce qu'**une première moitié (M1) des éléments d'interconnexion (6) comprend des éléments d'interconnexion (6) sensiblement parallèles entre eux, et **en ce qu'**une deuxième moitié (M2) des éléments d'interconnexion (6) comprend des éléments d'interconnexion (6) sensiblement parallèles entre eux, chaque cellule photovoltaïque (4) étant apte à être interconnectée à une autre cellule photovoltaïque (4) par le biais d'éléments d'interconnexion (6) interconnectés entre eux par le biais d'éléments d'interconnexion de regroupement (6c2) disposés de part et d'autre de la cellule photovoltaïque (4).

2. Module selon la revendication 1, **caractérisé en ce que** la première moitié (M1) des éléments d'interconnexion (6) comprend des éléments d'interconnexion (6) s'étendant selon une première direction (D1), et **en ce que** la deuxième moitié (M2) des éléments d'interconnexion (6) comprend des éléments d'interconnexion (6) s'étendant selon une deuxième direction (D2), les première (D1) et deuxième (D2) directions étant sensiblement perpendiculaires entre elles.

3. Module selon la revendication 1, **caractérisé en ce que** la première moitié (M1) des éléments d'interconnexion (6) comprend des éléments d'interconnexion (6) s'étendant selon une direction prédéterminée (D2), et **en ce que** la deuxième moitié (M2) des éléments d'interconnexion (6) comprend des éléments d'interconnexion (6) s'étendant selon cette même direction prédéterminée (D2), les éléments d'interconnexion (6) étant ainsi tous sensiblement parallèles entre eux.

4. Module selon l'une des revendications précédentes, **caractérisé en ce que**, pour chaque cellule photovoltaïque (4), les éléments d'interconnexion (6) présentent sensiblement la même longueur (I_{R}) au contact de la cellule photovoltaïque (4).

5. Module selon l'une quelconque des revendications précédentes, **caractérisé en ce que**, pour chaque cellule photovoltaïque (4), la longueur (I_{R}) au contact de la cellule photovoltaïque (4) des éléments d'interconnexion (6) est inférieure à la moitié de la largeur (I_{C}) et/ou de la longueur (L_{C}) d'une cellule photovoltaïque (4), notamment égale à la moitié de la largeur (I_{C}) et/ou de la longueur (L_{C}) d'une cellule photovoltaïque (4) diminuée de 2 à 6 mm.

6. Module selon l'une quelconque des revendications précédentes, **caractérisé en ce que**, pour chaque cellule photovoltaïque (4), la première moitié (M1) d'éléments d'interconnexion (6) est située sur une première moitié (C1) de la cellule photovoltaïque (4), et **en ce que** la deuxième moitié (M2) d'éléments d'interconnexion (6) est située sur une deuxième moitié (C2) de la cellule photovoltaïque (4).

7. Module selon les revendications 2 et 6, **caractérisé en ce que**, pour chaque cellule photovoltaïque (4), la première moitié (M1) des éléments d'interconnexion (6) comprend des éléments d'interconnexion (6), situés sur la première moitié (C1) de la cellule photovoltaïque (4), s'étendant verticalement selon la première direction (D1) d'un bord à l'autre de la cellule photovoltaïque (4), et **en ce que** la deuxième moitié (M2) des éléments d'interconnexion (6) comprend des éléments d'interconnexion (6) s'étendant horizontalement selon la deuxième direction (D2) d'un bord à l'autre de la cellule photovoltaïque (4), étant répartis en un premier ensemble (E1) d'éléments d'interconnexion (6) sur une première moitié (MC1) de la deuxième moitié (C2) de la cellule photovoltaïque (4) et un deuxième ensemble (E2) d'éléments d'interconnexion (6) sur une deuxième moitié (MC2) de la deuxième moitié (C2) de la cellule photovoltaïque (4), les premier (E1) et deuxième (E2) ensembles étant espacés l'un de l'autre, chaque élément d'interconnexion (6) du premier ensemble (E1) étant sensiblement aligné selon la deuxième direction (D2) avec un élément d'interconnexion (6) du deuxième ensemble (E2).

8. Module selon l'une quelconque des revendications précédentes, **caractérisé en ce que** la largeur des éléments d'interconnexion (6) est comprise entre 0,5 et 2,5 mm, et **en ce que** l'épaisseur des éléments d'interconnexion (6) est comprise entre 0,05 et 0,6 mm.

9. Module selon l'une quelconque des revendications précédentes, **caractérisé en ce qu'**il comporte des première et deuxième cellules photovoltaïques (4) interconnectées entre elles par le biais d'éléments d'interconnexion (6), les éléments d'interconnexion (6) de la face arrière (4b) de la première cellule photovoltaïque (4), notamment ceux s'étendant selon la deuxième direction (D2), étant interconnectés aux éléments d'interconnexion (6) de la face avant (4a) de la deuxième cellule photovoltaïque (4), notamment ceux s'étendant selon la deuxième direction (D2), par le biais d'éléments d'interconnexion de regroupement (6c2) de chaque côté des cellules photovoltaïques (4).

10. Module selon la revendication 9, **caractérisé en ce que** chaque élément d'interconnexion de regroupement (6c2) comporte, notamment sur sa surface destinée à être au contact des éléments d'interconnexion (6) de la face arrière (4b) de la première cellule photovoltaïque (4), notamment ceux s'étendant selon la deuxième direction (D2), un élément adhésif isolant (10), notamment un ruban adhésif isolant.

11. Module selon l'une quelconque des revendications précédentes, **caractérisé en ce que** les éléments d'interconnexion (6) sont solidarisés, notamment par soudure, à des pistes conductrices dénommées « busbars » reliant électriquement des doigts de collecte (8), les pistes conductrices et les doigts de collecte (8) étant formés par sérigraphie sur chaque cellule photovoltaïque (4).

12. Module selon la revendication 11, **caractérisé en ce que** les doigts de collecte (8) sont disposés de façon sensiblement parallèle à une diagonale de la cellule photovoltaïque (4).

13. Module selon la revendication 11, **caractérisé en ce que** les doigts de collecte (8) sont disposés selon une première direction (D1) sur une première moitié (C1) de la cellule photovoltaïque (4) et selon une deuxième direction (D2) sur une deuxième moitié (C2) de la cellule photovoltaïque (4).

14. Procédé d'interconnexion électrique de cellules photovoltaïques (4) d'un module photovoltaïque (1) par des éléments d'interconnexion (6), **caractérisé en ce que**, pour un nombre entier N supérieur ou égal à 2 d'éléments d'interconnexion (6) nécessaire par cellule photovoltaïque (4) présentant chacun une même longueur de base, le procédé comporte l'étape d'utilisation de 2 x N éléments d'interconnexion (6) par cellule photovoltaïque (4) présentant chacun une longueur égale à la moitié de ladite longueur de base, et **en ce qu'**une première moitié (M1) des 2 x N éléments d'interconnexion (6) comprend des éléments d'interconnexion (6) sensiblement parallèles entre eux, et qu'une deuxième moitié (M2) des 2 x N éléments d'interconnexion (6) comprend des éléments d'interconnexion (6) sensiblement parallèles entre eux

15. Procédé de fabrication d'un module photovoltaïque (1) selon l'une quelconque des revendications 1 à 13, **caractérisé en ce que** les cellules photovoltaïques (4) sont recouvertes d'une couche de sérigraphie comprenant des doigts de collecte (8) et des pistes conductrices dénommées « busbars » solidarisées, notamment par soudure, aux éléments d'interconnexion (6), la sérigraphie étant réalisée en au moins deux étapes comprenant respectivement la réalisation des doigts de collecte (8) à l'aide d'un écran pour doigts de collecte, et la réalisation des pistes conductrices (9) à l'aide d'un écran pour pistes conductrices.

16. Procédé selon la revendication 15, **caractérisé en ce que** les doigts de collecte (8) sont formés par sérigraphie de sorte à être orientés de façon parallèle à une diagonale de la cellule photovoltaïque (4).

17. Procédé selon la revendication 15, **caractérisé en ce que** les doigts de collecte (8) sont formés par sérigraphie de sorte à être orientés selon la première direction (D1) sur une deuxième moitié (C2) de la cellule photovoltaïque (4) et selon la deuxième direction sur une première moitié (C1) de la cellule photovoltaïque (4).
